Europäisches Patentamt

European Patent Office

Office européen des brevets

(19)

(11) Publication number: **0 261 301**
**A2**

(12) **EUROPEAN PATENT APPLICATION**

(21) Application number: 87104696.7

(51) Int. Cl.⁴: **H05K 3/42** , H05K 3/02

(22) Date of filing: 30.03.87

(30) Priority: 22.09.86 JP 224347/86
11.11.86 JP 268392/86

(43) Date of publication of application:
30.03.88 Bulletin 88/13

(84) Designated Contracting States:
DE FR GB

(71) Applicant: Ube Industries, Ltd.
12-32, Nishihonmachi 1-chome
Ube-shi, Yamaguchi-ken 755(JP)

Applicant: MEIKO ELECTRONICS CO., LTD.
5-14-15, Oogami
Ayase-shi Kanagawa-ken(JP)

(72) Inventor: Nakano, Tsunetomo c/o Chiba
Laboratories
Ube Industries, Ltd. 8-1, Goi-minami-kaigan
Ichihara-shi Chiba-ken(JP)
Inventor: Sakatani, Fumio c/o Chiba
Laboratories
Ube Industries, Ltd. 8-1, Goi-minami-kaigan
Ichihara-shi Chiba-ken(JP)
Inventor: Kanda, Takeshi
No. 3641, Miyahara
Fujisawa-shi Kanagawa-ken(JP)
Inventor: Miyazawa, Takeji
1-5-30, Tamagawa-gakuen
Machida-shi Tokyo(JP)

(74) Representative: Kraus, Walter, Dr. et al
Patentanwälte Kraus, Weisert & Partner
Thomas-Wimmer-Ring 15
D-8000 München 22(DE)

(54) **Process for the preparation of circuit-printed board having plated through-hole.**

(57) Improvement of a process for the preparation of a circuit-printed board having a plated through-hole comprising the steps of: processing a board having an electroconductive metal layer on both surfaces to form a through-hole; plating at least wall of the through-hole with an electroconductive metal; forming a resist layer in the form of a reverse pattern for a desired circuit pattern over both surfaces of the board except at least on the wall of the plated through-hole; depositing electrically an ionic resinous paint over the plated wall of the through-hole and an area of the surface of the board where the resist layer is not provided to form a deposited resinous paint layer thereon; removing the resist layer to expose the electroconductive layer of the board at the portion under the resist layer; removing the exposed portion of the electroconductive layer by etching; and removing the deposited resinous paint layer. The improvement comprises use of a photosensitive dry film for the formation of the reverse pattern. Another improvement comprises use of a specific aqueous solution for the removal of the resinous paint layer.

# PROCESS FOR THE PREPARATION OF CIRCUIT-PRINTED BOARD HAVING PLATED THROUGH-HOLE

## BACKGROUND OF THE INVENTION

### Field of the Invention

This invention relates to an improvement of a process for the preparation of a circuit-printed board such as a substrate having a printed circuit layer on both surfaces which has a plated through-hole.

### Description of prior art

As processes for the preparation of a circuit-printed board having at least one plated through-hole whose through-hole is plated with copper metal or other electroconductive metal on the wall (i.e, inner surface), there are known a plugging process, a solder-removing process and a tenting process. The plugging process comprises steps of plugging the through-hole having the copper-plated surface with a curable resin for protecting the copper-plated surface and performing an etching procedure. While the plugging process advantageously uses only a simple installation, this process requires a skilled technique and complicated manual processing. The solder-removing process and the tenting process disadvantageously involve very complicated steps and require skilled techniques and the use of expensive materials.

As an improvement of the process for the preparation of a circuit-printed board having a plated through-hole, there has been proposed a process comprising steps of processing a board having an electroconductive metal layer on both surfaces to form a through-hole; plating the through-hole with copper metal; forming a resist layer having a reverse pattern for a desired circuit pattern over both surfaces of the board except on the wall of the copper-plated through-hole by coating a resist solution; coating a specific resinous material (e.g., imidazole-type resin) over the wall and optionally the area near the copper-plated through-hole to form a chemically coated resin layer; removing the resist layer to expose the copper layer and/or the electroconductive layer under the resist layer; removing the exposed copper layer and the electroconductive layer by etching and removing the coated resin layer.

The above process is utilized in industry. However, this process has a number of drawbacks. For example, the resin layer coated on the surface of the through-hole is difficultly made to have uniform thickness, because the through-hole is too narrow to receive the resinous coating solution uniformly. Accordingly, the desired preparation of a uniform resin layer for the temporary protection of the plated copper layer sometimes fails and forms pin-holes in the resulting resin layer. In the subsequent etching stage, the pin-holes formed in the protective resin layer sometimes allows to permeate the etching solution therethrough to reach the copper layer, so that a portion the copper layer is etched out to produce an unacceptable product. This naturally decreases productivity of the circuit-printed board. Moreover, the stages of forming a resist-layer and forming a resin layer for the protection of the copper layer require too long time of period to decrease the productivity. The specific resin required for the preparation of the resin layer for the copper layer protection which is expensive is further disadvantageous.

As a further improvement, Japanese Patent Publica tion No. 55(1980)-36198 describes a process for preparing a circuit-printed board having a plated through-hole from an insulation substrate having through-hole in which all surfaces including the wall of the through-hole are coated with an electroconductive metal layer, comprising:

(1) a step of forming an alkali-removable ink layer (i.e., ink layer which is removable by treatment with an alkali agent) on the electroconductive layer at an unnecessary portion;

(2) a step of depositing electrically a water-soluble ionic resinous paint (which is exemplified by anionic resinous paints) on the electroconductive layer at a necessary portion and curing the deposited paint;

(3) a step of removing the alkali-removable ink layer using an aqueous alkali solution;

(4) a step of removing thus exposed electroconductive layer by etching; and

(5) a step of removing the cured resin layer.

## SUMMARY OF THE INVENTION

The present invention has an object to provide an improvement of a process for preparing a circuit-printed board having plated through-hole using an ionic resinous paint.

There is provided, in one aspect, by the present invention an improvement of a process for preparing a circuit-painted board having a plated through-hole comprising the steps of:

processing a board having an electroconductive metal layer on both surfaces to form a through-hole;

plating at least wall of the through-hole with an electroconductive metal;

forming a resist layer in the form of a reverse pattern for a desired circuit pattern over both surfaces of the board except at least on the wall of the plated through-hole;

depositing electrically an ionic resinous paint over the wall of the plated through-hole and an area of the surface of the board where the resist layer is not provided to form a deposited resinous paint layer thereon;

removing the resist layer to expose the electroconductive layer of the board at the portion under the resist layer;

removing the exposed portion of the electroconductive layer by etching; and

removing the deposited resinous paint layer,

wherein the step of forming a resist layer is performed by laminating a photo-sensitive dry film, exposing the laminated dry film to light in the form of the reverse pattern and then developing the exposed dry film to remove an unexposed portion.

In another aspect, the movement of the invention resides in that the step of depositing electrically an ionic resinous paint is performed using a cationic resinous paint; the step for removing the resist-coated layer is performed using an aqueous alkali solution; and the step removing the deposited resin layer is performed using an aqueous acid solution.

In a further aspect, the improvement resides in that; the step of depositing electrically an ionic resinous paint is performed using an anionic resinous paint; the step for removing the resist layer is performed using a diluted aqueous alkali solution containing an alkali agent in an amount of not more than 3.4 % by weight; and the step removing the deposited resin layer is performed using a concentrated aqueous alkali solution containing an alkali agent in an amount of not less less than 3.5 % by weight.

The improved processes of the present invention are favorable in the preparation of a circuit-printed board having plated through-hole, because the processes are satisfactory in preparing stable products with high productivity. Accordingly, the improved processes according to the present invention are favorably employable in industry.

## BRIEF DESCRIPTION OF THE DRAWING

Fig. 1 schematically shows the steps for preparing a circuit-printed board having plated through-hole according to the present invention.

Fig. 2 schematically shows the step for the resist layer using a photo-sensitive polymer film.

## DETAILED DESCRIPTION OF THE INVENTION

The process of the invention are described by referring to the attached drawings.

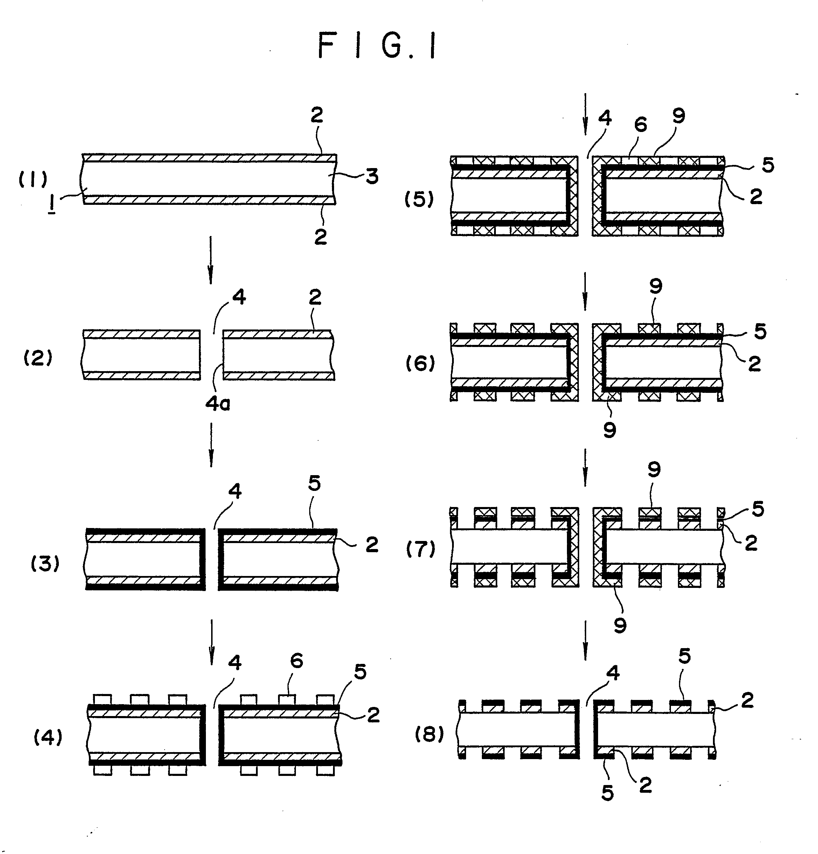

The attached Fig. 1 schematically shows the steps for the preparation of a circuit-printed board having a plated through-hole according to the invention.

The first step [(1) to (2) in Fig. 1] is for processing a board having an electroconductive metal layer on both surfaces to form through-hole.

The board 1 having an electroconductive metal layer 2 on both surfaces comprises a substrate 3 of an organic material (e.g., resin) or an inorganic material and a layer of an electroconductive metal (e.g., metallic copper) which is provided either surface of the substrate. The through-hole 4 can be formed by any conventional process to have an appropriate pore size such as a size of larger than approx. 100 $\mu$m, preferably a size of larger than approx, 500 $\mu$m.

The second step [(2) to (3) in Fig. 1] is for plating a wall 4a of the through-hole 4 and optionally the surface of the electroconductive metal layer 2 with an electroconductive metal such as copper metal to form a plated metal layer 5. Ordinarily, the plated metal layer is formed not only on the wall of the through-hole but also on whole surface of the electroconductive layer.

The electroconductive metal can be plated on the wall (i.e., inner surface) of the through-hole in any conventional process.

The third step [(3) to (4) in Fig. 1] is for forming a resist-coated layer 6 in the form of a reverse pattern for a desired circuit pattern over both surfaces of the board except on the wall and optionally on an area in the vicinity of the plated through-hole. The reverse pattern indicates a portion of an electroconductive layer to be finally removed from the board.

The formation of the resist layer can be done advantageously using a photo-sensitive dry film.

The dry film preferably contains as a main functional resin ingredient a copolymer of (meth)-acrylic acid or its ester and a copolymerizable monomer which contains an acid group such as carboxyl group in the molecular structure. The dry film of this type is soluble in an aqueous alkali (e.g., sodium carbonate) solution. A photo-sensitive dry film of the type is made insoluble in an aqueous alkali solution through cross-linking radical reaction upon exposure to light. The formed insoluble polymer, however, can be dissolved in an aqueous sodium hydroxide solution of 2 - 5 wt.% concentration. Such photo-sensitive dry films are known in the art.

The photo-sensitive dry film preferably has a thickness in the range of 25 to 50 $\mu$m.

Examples of the photo-sensitive dry films available commercially include LAMINAR TA, (thickness: 25 μm, 50 μm) of Dyachem Co., RISTON 3610, 3615, 3620 (thickness: 25 μm,. 40μm, 50 μm, respectively) of E.l. du Pont de Nemours & Co., Inc., PHOTEC PHT-862AF-25, -40, -50 (thickness: 25 μm, 40 μm, 50 μm, respectively) of Hitachi Chemical Co., Ltd., ALPHO W1025M, W1039M, W1050M (thickness: 25 μm, 40 μm, 50 μm, respectively) of The Nippon Synthetic Chemical Industry Co., Ltd. (25 μm), and MÜRON A (thickness: 25 μm, 50 μm of Muromachi Kagaku Kogyo Kaisha, Ltd.

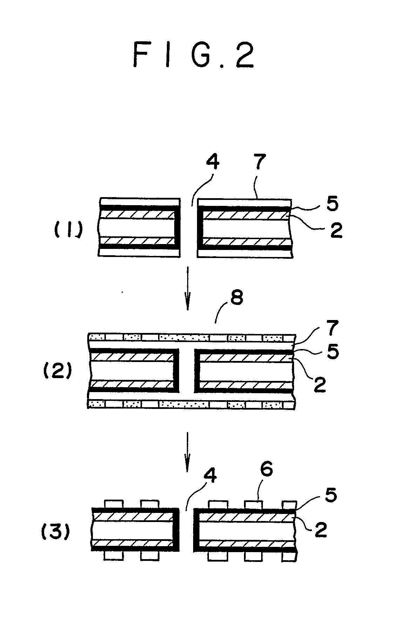

The process using the photo-sensitive dry film for forming the resist is illustratively shown in Fig. 2.

In the case of using the photo-sensitive dry film, the photo-sensitive resist layer can be prepared by laminating a photo-sensitive dry film 7 on the electroconductive layer 5 of the substrate 2, exposing the laminated dry film to light (i.e., radiation) in the form of the reverse pattern and then developing the exposed dry film to remove an unexposed portion. The lamination of the dry film can be done using a heat press roller heated at 80 to 160°C. The exposure of the heat resist film 7 can be done by exposing the film to light (e.g., light from a ultra-high voltage mecury lamp, 100-400 W, 10-40 seconds) through a negative film mask 8 of the reverse pattern, and the unexposed resist portion is removed by development to expose at least the wall of the plated through-hole and an area in the vicinity of the plated through-hole.

The use of the phto-sensitive dry film for the formation of resist layer is advantageous not only in the formation of a thick resist film, but also in easiness of post-treatment for removal of the resist film. The thick resist film is favorable for producing on the substrate a circuit pattern with improved high precision.

The formation of the resist layer can be done using, for instance, a silk-screen having such reverse pattern. In more detail, a curable resinous paint such as a thermosetting resin paint or a photosetting resin is painted on the electroconductive layer through the silk-screen in the form of the reverse pattern and then cured by application of heat or light to the printed resin layer to directly form a resist layer. Otherwise, a resinous paint containing a thermoplastic resin in a solvent is printed on the electroconductive layer through a silk-screen in the form of a reverse pattern and then dried to solidify to directly form a resist layer.

Alternatively, the resist layer can be formed indirectly according to the following steps. Initially, the board having the plated layer is coated with a solution containing a photo-resist and thus coated layer is dried to form a photo-resist film. The resist film is then exposed to light through a negative film mask of the reverse pattern and the unexposed resist if removed by development to expose at least the wall of the plated through-hole and optionally an area in the vicinity of the plated through-hole.

There is not specific limitation on the resist used in the third step, so long as the resist is easily removable by treatment with an aqueous alkali solution (an aqueous basic solution, preferably having a pH value of not lower than pH 11, more preferably of not lower than pH 12) and shows a sufficiently electric insulation in the following electric depositing stage. Such resist can be selected from known materials.

The fourth step [(4) to (5) in Fig. 1] is for depositing electrically a cationic or anionic resinous paint over the plated wall of the through-hole and an area of the surface of the board where the resist layer is not provided to form a deposited resinous paint layer thereon form a deposited resin layer 7. Thus, the deposited resin layer is formed on the surface where the electro conductive metal layer is exposed. In this electrical deposition step, the exposed electroconductive metal layer serves as an electrode.

The electrical deposition of an ionic resinous paint is already known. In a brief description, the electrical deposition comprises electrophoresing an electron-charged ionic material in an aqueous solution to reach a surface of an electroconductive material and then to deposit on the surface.

As is described hereinbefore, the present invention can utilize either of an anionic resinous paint (which is chargeable negatively in an aqueous solution to deposit on a positively charged material) and a cationic resinous paint (which is chargeable positively in an aqueous solution to deposit on a negatively charged material).

Examples of the cationic resinous paints include a water-soluble epoxy resin (e.g., polybutadiene having an epoxy group) which was prepared by reacting an epoxy resin with a primary or secondary amine to cleave at least a portion of epoxy groups in the epoxy resin by addition of said amine and neutralizing the resulting resin to make it water-soluble.

Examples of the anionic resinous paints include water-soluble resins such as a meleic acid-modified castor oil, maleic acid-modified liquid polybutadiene, maleic acid-modified epoxy resin, maleic acid-modified phenol, resin, maleic acid-modified resin with an ester group, alkyd resin, liquid polybutadiene having a carboxyl group as terminating group, styrene-alkyl alcohol resin, and acrylic resin. Any other anionic resinous paints such as paints containing a carboxyl group in the resin molecular to show a high acid value and to easily react with a base such as ammonia, an organic amine or an alkali metal hydroxide to form a salt can be employed.

The ionic resinous paint is generally employed in an aqueous solution containing 1-20 % by weight, preferably 5-15 % by weight, of the resinous component. Into the solution, a water-miscible organic solvent is preferably incorporated to enhance fluidity of the resinous solution. Preferred examples of the water-miscible organic solvents include alcoholic solvents such as isopropanol and methylcellosolve. The water-miscible organic solvent is advantageously incorporated into the aqueous solution in an amount ranging from approx. 2 to 10 % by weight. The resinous solution preferably contains a neutralizing agent such as ammonia or diethyleneamine in an appropriate amount to improve dispersability of the resinous material in the aqueous solution.

The electrically deposition employed in the process of the invention can be done in any known manner. Preferred conditions include a temperature for the deposition of lower than approx. 70°C, preferably in the range of 10 to 60°C, and a voltage for the deposition in the range of approx. 1 to 100 V, preferably in the range of 2 to 80 V.

The electrically deposited resinous layer is preferably washed with water, dried, and then heated at a temperature in the range of approx. 60 to 150°C. The heat-treated deposited layer is strongly fixed to the electroconductive layer so that the layer is sufficiently resistant to an alkali solution in the later step for removing the resist layer.

The fifth step [(5) to (6) in Fig. 1] is for removing the resist layer 6 to expose the plated layer 5 under the resist layer.

The resist layer 6 can be removed using a conventional developing solution such as an aqueous alkaline solution.

While the conventional acid solution or alkaline solution can be employed, the process using such conventional developing solution may have unfavorable features. For example, the cured ionic resinous layer is apt to be removed in the step for removing the alkali-removable ink layer using an aqueous alkali solution. In the case that the cured ionic resinous layer is resistant to the alkali solution in such step, the cured layer is sometimes not smoothly removed in the final step of removing the cured resin layer. Therefore, this process may have disadvantage in industry. Moreover, since the removal of the cured ionic resinous layer is performed using a volatile solvent such as a petroleum thinner, the disposal or recovery of such solvent is troublesome from the viewpoints of pollution of working conditions and public circumstances.

Accordingly, in the case that the cationic resinous paint is used for protection of the through-hole area, the removal of the resist-coated layer can be preferably carried out using an aqueous alkali solution containing an alkali agent in an amount of 0.1 to 10 % by weight, more preferably in an amount of 0.5 to 8% by weight. The aqeuous solution preferably contains an alkali agent such as sodium hydroxide, potassium hydroxide or sodium carbonate. The aqueous alkali solution may contain a water-miscible organic solvent. The removal of the resist layer can be done by a known method such as that involving immersing the board in the alkali solution or that involving jetting alkali solution onto the surfaces of the board. The temperature of the alkali solution ranges generally from 0 to 60°C, preferably from 5 to 55°C.

In the case that the anionic resinous paint is used for protection of the through-hole area, the removal of the resist-coated layer is preferably carried out using a diluted aqueous alkali solution containing an alkali agent in an amount of not more than 3.4 % by weight, more preferably in an amount of not more than 3.0 % by weight. The diluted aqueous alkali solution preferably shows a pH value in the range of 12.0 to 13.6. The use of such diluted aqueous alkali solution is preferred to essentially keep the electricity deposited anionic resinous paint layer from separation from the plated layer around the through-hole portion.

The aqueous alkali solution employed for this process also preferably contains an alkali agent such as sodium hydroxide, potassium hydroxide or sodium carbonate. The aqueous alkali solution may contain a watermiscible organic solvent. The removal of the resist layer can be done by a known method such as that involving immersing the board in the alkali solution or that involving jetting the alkali solution onto the surfaces of the board. The temperature of the alkali solution ranges generally from 0 to 60°C, preferably from 5 to 55°C.

The sixth step [(6) to (7) in Fig. 1] is for removing the exposed electroconductive layers 2, 5 by etching.

The etching of the exposed electroconductive layers 2, 5 can be done in any known manner using a known etching solution.

The seventh step [(7) to (8) in Fig. 1] is for removing the deposited resin layer 9 from the plated layer 5.

In the case that the cationic resinous paint is used for protection of the through-hole area in the aforementioned fifth step, the removal of the cationic reinous paint layer is done using a aqueous acid solution which preferably contains an acid in an amount of not more than 10 % by weight, more preferably in an amount of not more than 5 % by weight. The acid preferably is sulfuric acid or acetic acid. The procedure can be done at a temperature ranging from 0 to 100°C, preferably from 5 to 50°C for a period ranging from approx. 1 to 60 min., prefer ably from 2 to 30 min.

In the case that the anionic resinous paint is used for protection of the through-hole area in the aforementioned fifth step, the removal of the anionic reinous paint layer is preferably done using a concentrated aqueous alkali solution which contains an alkali agent in an amount of not less than 3.5 % by weight, more preferably in an amount ranging from 3.6 to 10 % by weight. The concentrated aqueous alkali solution preferably shows a pH value of not lower than pH 13.6. The use of such concentrated aqueous alkali solution is necessary to completely remove the electrically deposited anionic resinous paint layer from the copper layer around the through-hole portion. Examples of the alkali agents include those mentioned in the description of the fifth step. The procedure can be done preferably at a temperature ranging from 0 to 80°C.

The concentrated aqueous alkali solution preferably contains an organic solvent in an amount ranging from 1 to 30 % by weight, more preferably from 5 to 25 % by weight. The concentrated aqueous alkali solution containing an ornaic solvent in such amount is favorable to smoothly remove the electronically deposited-anionic resinous paint layer.

There is no specific lamination on the organic solvent, so long as it is well miscible with the concentrated aqueous alkali solution and it can dissolve the anionic resinous paint layer or can cause the paint layer swelling. The organic solvent is preferably selected from an aprotic polar organic solvent, ethylene glycol, a polyethylene glycol, an ethylene glycol derivative, a monohydric water-soluble alcohol, and a polyhydric water-soluble alcohol. Examples of the aprotic polar organic solvents include amide-type solvents such as N,N-dime-thylformamide, N,N-dimethylacetamide, N-methyl-2-pyrro lidone and sulfoxide-type solvents such as dimethylsulfoxide and diethylsulfoxide. Examples of the polyethylene glycols include diethylene glycol, triethylene glycol and tetraethylene glycol. Examples of the ethylene glycol derivative include ethylene glycol monoalkylethers such as ethyleneglycol monomethylether and polyethylene glycol mono-or di-alkylethers. Examples of the monohydric water-soluble alcohols include methanol, ethanol, isopropanol and butanol. Examples of the polyhydric water-soluble alcohols include pentaerythritol and glycerol.

The present invention is further described by the following examples.

Reference Example 1: Preparation of Modified Alkyd Resin for Anionic Resinous Paint

A mixture of 620 g of soy bean oil-fatty acid (acid value: 155), 500 g of rosin (acid value: 170), 600 g of tall oil fatty acid (acid value: 170), 140 g of linolic acid, 140 g of linolenic acid, and 300 g of maleic anhydride were reacted at 200°C for 3 hours under nitrogen atmosphere and then cooled to 100°C. To the reaction mixture were added 150 mℓ of xylene, 1,000 g of pentaerythritol and 900 g of trimellitic anhydride. The resulting mixture was then heated to 150°C, and when the acid value reached 100, the reaction mixture was cooled to terminate the reaction. The xylene was removed under reduced pressure in this stage. The reaction mixture was further cooled to 70°C, and to the mixture were added 680 g of isopropyl alcohol and 500 g of triethylamine for dissolving the solid current of the mixture in the added solvent. Thus, a modified alkyd resin solution containing a solid content of approx. 70 wt.% was prepared.

To 100 g of the above modified alkyd resin solution were added 60 g of a water-soluble melamine resin (Uban 165 of Mitsui-Toatsu Chemical Industry Co., Ltd., nonvolatile component 70 %) and 2 g of water-soluble silicone resin (SH 29PA of Toray Silicone Co., Ltd.). The mixture was well admixed, and to the mixture were added 20 g of titanium dioxide and 20 g of clay (mean particle size 50 μm for both). The mixture was further well admixed to prepare a resinous composition for electrical deposition.

To the resinous composition was added water to adjust the non-volatile component content to 15 %. After the resinous composition was dispersed in water, the resulting mixture was adjusted to have pH 8.2 by addition of triethylamine to obtain an alkyd resin-containing anionic resinous paint for electrical deposition.

Example 1

A substrate (glass-epoxy resin plate having a copper layer on both surfaces, 35 cm x 35 cm, thickness 1.6 mm) was processed to have 2,000 through-holes (diameter: 500 μm) therein and was plated with a copper metal on the walls of the holes and both surfaces of the substrate. A photo-sensitive dry film (LAMINAR TA, thickness 50 μm, tradename of dry film photopolymer of Danachem Co.) was laminated over the copper layer on both surfaces of the substrate at 160°C by means of a heat press roller. The laminated film was cooled, and on the cooled film was placed a negative film mask of a reverse pattern for a circuit pattern. The film was then exposed to a high voltage mercury lamp at 250 W for 10 to 20 seconds. After the exposure was complete, the film was treated by 1.0 wt.% aqueous sodium carbonate solution to wash out an unexposed portion of the film. Thus, an exposed resist layer (thickness 50 $\mu$m) in the form of the reverse pattern was formed. The resulting substrate had a circuit pattern of an exposed copper metal (minimum line width: 100 $\mu$m, distance between adjoining lines: 150 $\mu$m) and a non-circuit area coated with the resist layer.

The processed substrate was introduced into the alkyd resin-type anionic resinous paint prepared in Reference Example 1. In the paint were placed a stainless steal plate (cathode). Electrical deposition was carried out by applying direct current at voltage of 70 V for 1 minute to deposit the cationic modified resin on the copper-exposed area (i.e., wall surface of the through-holes and the portion where no resist layer was formed). Thus formed anionic modified resin had thickness of 25 $\mu$m.

The substrate was then washed with water for removing an excessive paint, dried at 130°C for 20 minutes in a hot-air oven, and cooled. The substrate was then immersed in aqueous sodium hydroxide solution (2 wt.% solution) at 50°C for 1 minute to remove the resist layer from the substrate.

The copper layer at a portion which was exposed in the above-treatment was washed with water and dried, and then was etched out with aqueous ferric chloride solution (40 Baumé) at 50°C. By this treatment, the copper-plated layer and the under-coating copper layer were removed in the area where no circuit should be formed.

The substrate having been processed by the etching was washed with water and then immersed in a mixture of 80 weight parts of aqueous sodium hydroxide solution (4 wt.% solution) and 20 weight parts of diethylene glycol at 50°C for 5 minutes to remove the anionic resinous paint layer.

Thus, a board having a painted circuit on both surfaces in which both circuits were electrically connected via the plated copper layer in the through-holes was pre pared. It was confirmed that the circuit pattern of line width 100 $\mu$m was foamed with high precision.

Reference Example 2: Preparation of Water-Soluble Modified Polybutadiene For Cationic Resinous Paint

To 108 g of n-hexane were added 12 g of oils-1,4-polybutadiene, 48 g of aqueous hydrogen peroxide solution (concentration: 31 wt.%) and 1 g of formic acid. The resulting solution was heated to 50°C for 3 hours for obtaining an epoxidized polybutadiene (epoxy ratio: 3.7 molar %). The obtained epoxized polybutadiene was heated in 150 ml of morpholine at 120°C for 5 hours in the presence of 0.16 g of phenol to cleave the epoxy group and then was neutralized with lactic acid to prepare a water-soluble modified polybutadiene for the use in the following Example 2 as a cationic resinous paint.

Reference Example 3: Preparation of Water-Soluble Modified Polybutadiene For Anionic Resinous Paint

In 40 ml of 1,4-dioxane was dissolved 20 g of maleic acid-modified polybutadiene (NISSO-PB BN-1015, tradename, available from Nippon Soda Co., Ltd., Japan). To the resulting solution was added 50 ml of ethylene glycol butylether. The resulting solution was heated at 80°C for 3 hours to cleave maleic anhydrides group to obtain a monoester of carboxylic acid of polybutadiene. The produced polymer was then neutralized with ammonia to prepare a water-soluble modified polybutadiene for the use in the following Example 3 as an anionic resinous paint.

Reference Example 4: Preparation of Modified Alkyd Resin For Anionic Resinous Paint

An alkyd resin solution (APROPLAZ 1271, tradename, available from Nippon Catalyst Chemical Industry Co., Ltd., Japan) was converted into a solution in ethylene glycol containing involatile component in an amount of 70 wt.%. The resulting solution was diluted with water to prepare a solution containing involatile component in an amount of 15 wt.%, and then neutralized with triethylamine to prepare a solution of a modified alkyd resin for the use in the following Example 5 as an anionic resinous paint.

Example 2

A substrate having a copper layer on both surfaces was processed to have through-holes (diameter: 500 $\mu$m) and plated with a copper metal. A resist (Etching Resist SER-400BL, tradename, available from Sanei Chemical Co., Ltd., Japan) was coated over the copper layer by a screen printing method to give a resist layer having a reverse pattern. The coating of the resist was applied over the whole surface of the corner of layers of the substrate except on the wall of the through-holes as well as a portion near the through-holes.

Into a beaker was introduced 100 ml of a cationic resinous paint (rotary viscosity at 25°C: 100 cp, pH: 6.0) containing the water-soluble modified polybutadiene prepared in Reference Example 2. In the paint were placed a carbon anode and the processed substrate (cathode) with a space of 20 mm therebetween. Electrical deposition was carried out by applying a voltage of 5V between the anode and the cathode for 2 minutes under slow stirring to deposit the modified polybutadiene on the walls of the through-holes and the portions near the through-holes.

The substrate was then washed with running water for 3 minutes dried at 60°C for 30 minutes in a hot-air oven, and treated with aqueous sodium hydroxide solution (5 wt.% solution) to remove only the resist layer from the substrate.

The copper layer at a portion which was exposed in the above-treatment was etched out with an alkali etching solution (Alkalietch: tradename, available from Yamatoya Shokai Co., Ltd., Japan) at 40°C for 10 minutes.

The substrate having been processed by the etching was washed with water and then immersed in aqueous sulfuric acid (2 wt.% solution) at 25°C for 5 minutes to remove the cationic resinous paint layer of the modified polybutadiene.

Thus, a board having a printed circuit on both surfaces in which both circuits were electrically connected via the plated copper layer in the through-holes was prepared.

## Example 3

A substrate having a copper layer on both surfaces was processed in the same manner as in Example 2 to have through-holes (diameter: 500 μm) plated with a copper metal and to have a resist layer over the whole surface of the copper layer of the substrate except the walls of the through-holes as well as portions near the through-holes.

In 50 ml of water was dissolved 10 g of the water-soluble modified polybutadiene prepared in Reference Example 3, and then resulting solution was neutralized to pH 8 by addition of ammonia to prepare an anionic resinous paint. In the paint were placed a stainless steel cathode and the processed substrate (anode) with a space of 20 mm therebetween. Electrical deposition was carried out by applying a voltage of 30 V between the anode and the cathode for 3 minutes to deposit the modi fied polybutadiene on the walls of the through-holes and the portion near the through-holes.

The substrate was then washed with running water for 3 minutes, dried at 100°C for 15 minutes in a hot air oven, and immersed in aqueous sodium hydroxide solution (2 wt.% solution, pH: 13.51) at 40°C for 25 seconds to remove only the resist layer from the substrate.

The copper layer at the portion which was exposed in the above-treatment was etched out with aqueous ferric chloride solution (40 Be) at 50°C for 3 minutes.

The substrate having been processed by the etching was washed with water and then immersed in aqueous sodium hydroxide solution (5 wt.% solution, pH: 13.82) at 40°C for 10 minutes to remove the anionic resinous paint layer of the modified polybutadiene.

Thus, a board having a printed circuit on both surfaces in which both circuits were electrically connected via the plated copper layer in the through-holes was prepared.

## Example 4

The Procedures of Example 3 were repeated except that the removal of the anionic resinous paint layer was carried out using a mixture of 80 weight parts of aqueous sodium hydroxide solution (5 wt.% solution, pH: 13.82) and 20 weight parts of diethylene glycol monoethylether at 40°C for 5 minutes to prepare a board having a printed circuit on both surfaces in which both circuits were electrically connected via the plated copper layer in the through-holes.

The period of time required for the removal of the anionic resinous paint layer was shortened to approximately a half of the period required for the same removal procedure in Example 3.

## Example 5

The procedures of Example 4 were repeated except that the anionic resinous paint prepared in Reference Example 4 was employed and the thermal drying process of the coated anionic resinous layer was carried out at 130°C for 10 minutes to prepare a board having a printed circuit on both surfaces in which both circuits were electrically connected via the plated copper layer in the through-holes.

The period of time required for the removal of the anionic resinous paint layer was shortened to approximately 2 minutes.

## Example 6

The procedures of Example 2 using cationic resinous paint were repeated except that a resist ink (UV Setting Resist Ink EP 110, tradename, available from Toyobo Co., Ltd., Japan) containing a photosetting resin was printed through a screen on the copper layer on the surface of the substrate and the printed ink was cured under irradiation of light from a ultra-high voltage mercury lamp at 50 W/cm. for 1.5 minutes to prepare a board having a printed circuit on both surfaces in which both circuits were electrically connected via the plated copper layer in the through-holes.

## Claims

1. A process for the preparation of a circuit-printed board having a plated through-hole comprising the steps of:
processing a board having an electroconductive metal layer on both surfaces to form a through-hole;
plating at least wall of the through-hole with an electroconductive metal;
forming a resist layer in the form of a reverse pattern for a desired circuit pattern over both surfaces of the board except at least on the wall of the plated through-hole;
depositing electrically an ionic resinous paint over the wall of the plated through-hole and an area of the surface of the board where the resist layer is not provided to form a deposited resinous paint layer thereon;
removing the resist layer to expose the electroconductive layer of the board at the portion under the resist layer;
removing the exposed portion of the electroconductive layer by etching; and
removing the deposited resinous paint layer,
characterized in that the step of forming a resist layer is performed by laminating a photo-sensitive dry film, exposing the laminated dry film to light in the form of the reverse pattern and then developing the exposed dry film to remove an unexposed portion.

2. The process as claimed in claim 1, wherein the dry film has a thickness in the range of 25 to 50 μm.

3. The process as claimed in claim 1, wherein the dry film contains as a main ingredient a copolymer of (meth)acrylic acid or its ester and a copolymerizable monomer which contains an acid group in the molecular structure.

4. The process as claimed in claim 1, wherein the dry film contains as a main ingredient a copolymer of (meth)acrylic acid or its ester and a copolymerizable monomer which contains carboxyl group in the molecular structure.

5. A process for the preparation of a circuit-printed board having a plated through-hole comprising the steps of:
processing a board having an electroconductive metal layer on both surfaces to form a through-hole;
plated at least wall of the through-hole with an electroconductive metal;
forming a resist layer in the form of a reverse pattern for a desired circuit pattern over both surfaces of the board except at least on the wall of the plated through-hole, by coating a resist solution;
depositing electrically an ionic resinous paint over the wall of the plated through-hole and an area of the surface of the board where the resist layer is not provided to form a deposited resinous paint layer thereon;
removing the resist layer to expose the electroconductive layer of the board at the portion under the resist layer;
removing the exposed portion of the electroconductive layer by etching; and
removing the deposited resinous paint layer,
characterized in that the step of depositing electrically an ionic resinous paint is performed using a cationic resinous paint; the step for removing the resist layer is performed using an aqueous alkali solution; and the step removing the deposited resin layer is performed using an aqueous acid solution.

6. The process as claimed in claim 5, wherein the cationic resinous paint comprises a water-soluble epoxy resin prepared by reacting an epoxy resin with a primary or secondary amine to cleave at least a portion of epoxy groups in the epoxy resin by addition of said amine and neutralizing the resulting resin to make it water-soluble.

7. The process as claimed in claim 5, wherein the aqueous alkali solution contains an alkali agent in an amount of 0.1 to 10 % by weight.

8. The process as claimed in claim 5, wherein the aqueous alkali solution contains an alkali agent in an amount of 0.5 to 8 % by weight.

9. The process as claimed in claim 5, wherein the aqueous alkali solution contains an alkali agent selected from the group consisting of sodium hydroxide, potassium hydroxide and sodium carbonate.

10. The process as claimed in claim 5, wherein the aqueous acid solution contains an acid in an amount of not more than 10 % by weight.

11. The process as claimed in claim 5, wherein the aqueous acid solution contains an acid in an amount of not more than 5 % by weight.

12. The process as claimed in claim 5, wherein the aqueous acid solution contains an acid selected from the group consisting of sulfuric acid and acetic acid.

13. A process for the preparation of a circuit-printed board having a plated through-hole comprising the steps of:

processing a board having an electroconductive metal layer on both surfaces to form a through-hole;

plating at least wall of the through-hole with an electroconductive metal;

forming a resist layer in the form of a reverse pattern for a desired circuit pattern over both surfaces of the board except at least on the wall of the placed through-hole, by coating a resist solution;

depositing electrically an ionic resinous paint over the wall of the plated through-hole and an area of the surface of the board where the resist layer is not provided to form a deposited resinous paint layer thereon;

removing the resist layer to expose the electroconductive layer of the board at the portion under the resist layer;

removing the exposed portion of the electroconductive layer by etching; and

removing the deposited resinous paint layer,

characterized in that the step of depositing electrically an ionic resinous paint is performed using an anionic resinous paint; the step for removing the resist layer is performed using a diluted aqueous alkali solution containing an alkali agent in an amount of not more than 3.4 % by weight; and the step removing the deposited resin layer is performed using a concentrated aqueous alkali solution containing an alkali agent in an amount of not less less than 3.5 % by weight.

14. The process as claimed in claim 13, wherein the anionic resinous paint comprises a water-soluble resin having carboxyl group.

15. The process as claimed in claim 13, wherein the anionic resinous paint comprises a water soluble resin selected from the group consisting of a meleic acid-modified castor oil, maleic acid-modified liquid polybutadiene, maleic acid-modified epoxy resin, maleic acid-modified phenol resin, maleic acid-modified resin with an ester group, alkyd resin, liquid polybutadiene having a carboxyl group as terminating group, styreneallyl alcohol resin, and acrylic resin.

16. The process as claimed in claim 13, wherein the diluted aqueous alkali solution contains an alkali agent selected in an amount of not more than 3.0 % by weight.

17. The process as claimed in claim 13, wherein the diluted aqueous alkali solution contains an alkali agent in an amount to have a pH value in the range of 12.0 -13.6.

18. The process as claimed in claim 13, wherein the diluted aqueous alkali solution contains an alkali agent selected from the group consisting of sodium hydroxide, potassium hydroxide and sodium carbonate.

19. The process as claimed in claim 13, wherein the concentrated aqueous alkali solution contains an alkali agent in an amount ranging from 3.6 to 10 % by weight.

20. The process as claimed in claim 13, wherein the concentrated aqueous alkali solution contains an alkali agent in an amount to have a pH value of higher than 13.6

21. The process as claimed in claim 13, wherein the concentrated aqueous alkali solution contains an alkali agent selected from the group consisting of sodium hydroxide, potassium hydroxide and sodium carbonate.

22. The process as claimed in claim 13, wherein the concentrated aqueous alkali solution contains an organic solvent in an amount ranging from 1 to 30 % by weight.

23. The process as claimed in claim 13, wherein the concentrated aqueous alkali solution contains an organic solvent in an amount ranging from 1 to 30 % by weight, the organic solvent being selected from the group consisting of an aprotic polar organic solvent, ethylene glycol, a polyethylene glycol, an ethylene glycol derivative, a monohydric water-soluble alcohol, and a polyhydric water-soluble alcohol.

# F I G. I

(1)

(2)

(3)

(4)

(5)

(6)

(7)

(8)

# F I G. 2